Europäisches Patentamt

European Patent Office

Office européen des brevets

(19)

(11) Publication number: **0 157 081 B1**

# EUROPEAN PATENT SPECIFICATION

(45) Date of publication of patent specification: **04.12.91**    (51) Int. Cl.⁵: **H05K 13/06, H01R 43/28**

(21) Application number: **85100408.5**

(22) Date of filing: **17.01.85**

(54) **Device for dispensing controlled lengths of material.**

(30) Priority: **05.03.84 US 586171**

(43) Date of publication of application:
**09.10.85 Bulletin 85/41**

(45) Publication of the grant of the patent:
**04.12.91 Bulletin 91/49**

(84) Designated Contracting States:
**DE FR GB**

(56) References cited:
**EP-A- 0 076 773**
**US-A- 3 165 207**

(73) Proprietor: **International Business Machines
Corporation
Old Orchard Road
Armonk, N.Y. 10504(US)**

(72) Inventor: **Houser, David Erle
9 Crescent Drive
Appalachin New York 13732(US)**
Inventor: **Morenus, Richard Jay
316 Hollerith Avenue
Endwell New York 13760(US)**

(74) Representative: **Gaugel, Heinz, Dipl.-Ing.
Schönaicher Strasse 220
W-7030 Böblingen(DE)**

EP 0 157 081 B1

## Description

This invention relates to the field of materials handling and more particularly pertains to steppers for dispensing controlled lengths of electrical wire for use in printed circuit boards.

In the automated manufacture of circuit boards in which a length of electrical wire connects electrical devices such as pin sockets and the like, the wire must be dispensed automatically usually from a spool in lengths that are accurate within a close tolerance of the actual length between the parts to be connected. In the prior art the devices that produce these lengths include a large quantity of the dispensed material wound on a spool that is mounted for rotation about its axis and driven in rotation by an electrical motor energized and de-energized for periods of time that produce a segment of wire of the desired length. A knife edge or other cutting means is provided to sever the wire segment from the wire that is rolled on the spool.

Devices of this type, however, prove to be inaccurate in producing wire of the desired length because of the rotational inertia of the spool and the inability to start and stop the motor precisely as required to produce the desired length of the material.

The device as claimed in claim 1 is intended to solve this problem. The dependent claims are related to embodiments of the invention.

The device according to embodiments of this invention can dispense controlled and predetermined lengths of material such as wire, metal bands, ribbon tapes, paper, etc. The device includes a source of pressurized gas such as a compressor, air pump or the like and a track within which the dispensed material is guided and moves through the device. The material is first threaded along the track from an inlet end of the device to an outlet end where the material is dispensed in accurately controlled lengths. Along the track spaced longitudinally from one another are first and second surfaces against which the material can be clamped, fixed or held against movement. Located in the space between the clamping surfaces and along the track is a displacement region which defines surfaces that are spaced laterally one from another, the lengths of the surfaces of the displacement region being unequal. The difference in length of the surfaces of the displacement region establishes the length of the material that is drawn into, advanced through and dispensed from the device during each control cycle. A housing further defines manifolds within which pressure drops are produced between the clamping surfaces and laterally spaced surfaces of the displacement region and the source of air pressure by way of pneumatic electronically controlled valves actuated sequentially during each cycle.

The valves selectively open and close communication between the outlet side of the pressure source and the manifolds according to the control of a computer, microprocessor or other control means, which energizes electrical solenoid windings that produce the on-off disposition of the valves. The control means selectively opens and closes the valves so that the material to be dispensed is held against the clamping surfaces due to the effect of air pressure admitted to the associated manifolds. Within the displacement region, the control valves cause the air pressure to move the dispensed material selectively against one or the other of the laterally spaced surfaces. In this way, by selectively clamping the leading portion of the wire segment located within the device and releasing the trailing portion of the wire segment, the material is drawn into the device by concurrently opening the valve that causes the material to conform to the longer surface of the displacement region. Then, the material is forced outward from the device by first clamping the trailing portion of the wire and releasing the leading portion of the wire located within the device and opening the valve that causes the material to conform to the surface of the displacement region having the shorter length.

This device can be adapted to dispense a band of metal using a programmable actuator that selectively energizes an electromagnet, which when energized causes the band to conform alternately to the longer and shorter surfaces of the displacement region and to become clamped against the surfaces of the forward and trailing clamping regions of the device.

The features and advantages of this invention will be apparent from the following more particular description of the preferred embodiments of the invention illustrated in the accompanying drawings in which:

Figure 1   is a top view of the dispenser according to this invention showing a general arrangement of the track, the control valves, the pressure source and the means for controlling the operation of the valves.

Figure 2   is a side elevation view of the device of Figure 1.

Figure 3   is an isometric view showing the stepper plate and adapter plate spaced from one another and illustrating the several positions of a segment of a length of wire being dispensed by the device.

Figure 4   is a partial cross-sectional view taken at plane IV-IV of Figure 1.

Figure 5   is a partial cross-sectional view taken at plane V-V of Figure 1.

Figure 6 is a timing diagram showing the relative occurrences of the changes of state of the pneumatic valves that pressurize the manifolds.

Figure 7 is a top view of a stepper according to this invention.

Figure 8 is a top edge view of the stepper of Figure 7.

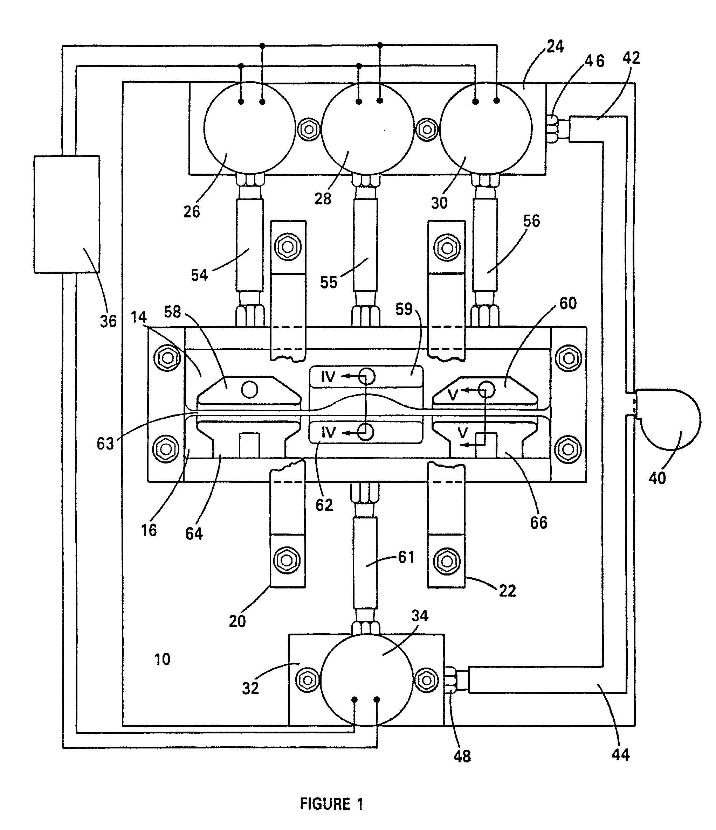

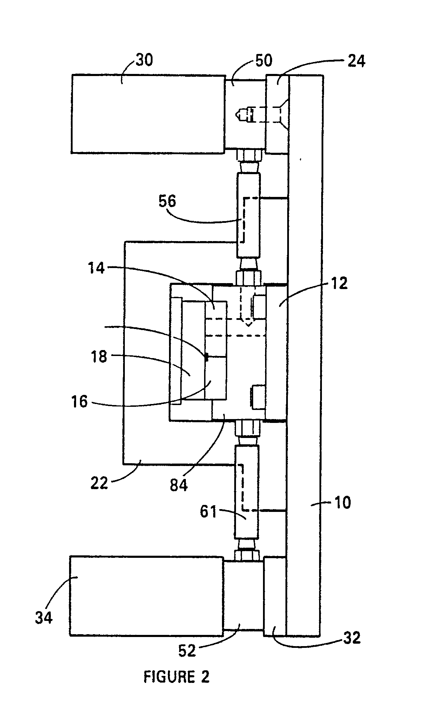

Referring first to Figures 1 and 2, the wire dispensing device or stepper according to the present invention includes a base plate 10; a mounting block 12 bolted to the base plate; a stepper plate 14 and actuator plate 16, which are mounted on the mounting block; a cover 18; and clamps 20, 22, which are bolted to the base plate and support the cover against the effect of pressurized gas within the device.

A valve plate 24 fixed to the base plate provides a surface on which three valves 26, 28, 30 are mounted. A second valve plate 32 mounted to the base plate at its opposite end provides a surface on which a fourth valve 34 is mounted. The valves may be electronic valves that control pneumatic fluid circuits by way of a poppet diaphragm whose state is determined by electronic control. Valves of this type are produced by Clippard Instrument Laboratory, Inc., identified as model numbers EV-3-12, normally closed three-way valves adapted for use with 12 volt potential. Valves 26, 28, 30 and 34 are three-way valves, whose on state opens communication between the valve inlet and outlet and whose off state closes this communication and also opens the valve to exhaust.

The solenoids that control the operation of these valves are connected to the output ports of a computer, microprocessor or other control device 36 that supplies current selectively to the windings of the solenoids which are integral with each valve assembly.

The pneumatic circuit includes a source 40 of pressurized air or inert gas connected by ducts 42, 44 to the intake fittings 46, 48 by means of which the valves are pressurized. The outlet ports of valves 26, 28 and 30 are connected by conduits 54-56 to manifolds 58, 59, 60 formed in stepper plate 14 The outlet port of valve 34 is connected by conduit 61 to a manifold 62 formed in actuator plate 16. Stepper plate 14 and actuator plate 16 define a track 63 within which the dispensed material is guided and contained as it passes through the dispenser.

When valves 26, 28, 30 and 34 are open, the outlet of pressure source 40 is connected to manifolds 58, 59, 60 and 62, respectively. When valves 26, 28 or 30 and 34 are closed, the outlet side of the pressure source is closed to manifolds 58, 59, 60 and 62, respectively. However, when the valves are de-energized, the manifolds are opened to the atmosphere and closed to the pressure source. Manifolds 64 and 66 are continuously open to atmosphere.

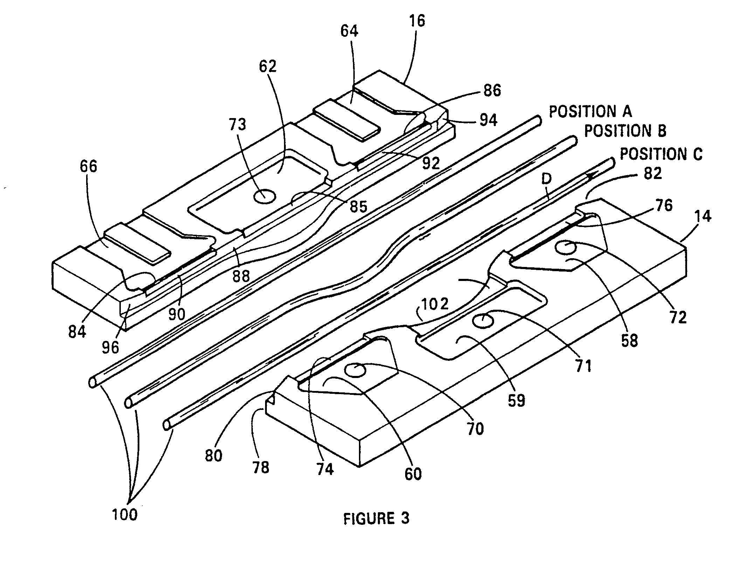

Turning now to Figure 3, the manifolds 58, 59, 60 of the stepper plate 14 each have a pressure port 72, 71, 70 by means of which valves 26, 28, 30, respectively, connect the pressure source to the manifolds. The depth to which the manifolds are formed in the plate is greater than the depth of the passages 74, 75, 76, which communicate the manifolds with the track 63. At each longitudinal end of the stepper plate, vertical surface 78 is relieved as at 80, 82 to form a lead surface, which in combination with lead surfaces 96 and 94, respectively, of plate 16 directs the dispensed material into the track.

Actuator plate 16 is similarly formed with three manifolds 62, 64, 66 each formed at approximately the same depth in the actuator plate. Manifold 62 has a pressure port 73 by means of which valve 34 communicates the pressure source to manifold 62. The interior end of manifolds 62, 64, 66 have surfaces 84, 85, 86 formed in the upper surface of the actuator plate shallower than the bottom surface of manifolds 62, 64, 66. These surfaces permit communication between the respective manifolds and track 63, which is defined by the vertical surface 78 of stepper plate 14, that extends the full length of plate 14 and the vertical surface 88 of the actuator plate that extends along the full length of plate 16. Inclined surface 90 forms a transition surface joining vertical surface 88 and horizontal surface 84 at the outlet of manifold 66. Inclined surface 92 forms a transition surface between vertical surface 88 and horizontal surface 86 at the outlet of manifold 64. Relief surfaces 94, 96 at opposite longitudinal ends of actuator plate 16 form lead surfaces that guide the material into track 63.

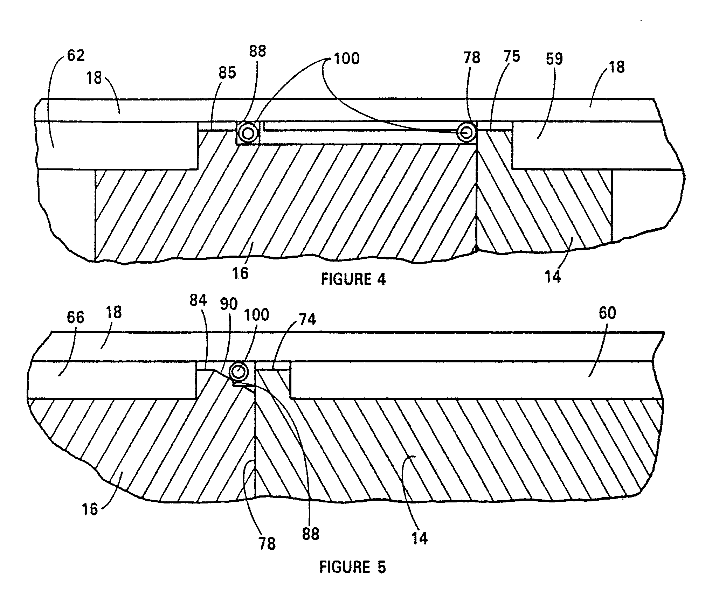

Referring now to Figures 4 and 5, it can be seen that the material to be dispensed, which in the described example is insulated copper wire 100, is guided and contained within the track defined by vertical surfaces 78, 88. For example, the track defines a displacement region that can be pressurized from either manifold 59 or 62 by way of the passages located between cover 18 and surfaces 75 or 85. When manifold 59 is pressurized and manifold 62 is depressurized, the wire is displaced within the track away from manifold 59 and toward manifold 62. Similarly when manifold 62 is pressurized and manifold 59 is depressurized, the wire is displaced within the track away from manifold 62 and toward manifold 59. In Figure 5 it can be seen that the wire can be held on inclined clamping surface 90 against longitudinal movement when manifold 60 is pressurized because the pressure in the passage that surface 74 defines is greater than the pressure in the passage that passage 84 defines. A pressure drop across the dispensed material forces the material against surface 90. When manifold 60 is pressurized and the wire is clamped between the cover and surface 90, the wire is restrained against movement parallel to its axis. On the other hand, when manifold 60 is depressurized, the wire is released from surface 90 and into the track between surfaces 78, 88 where it is free to move axially. The passage defined by cover 18 and surface 84 communicates manifold 66 with the track. Clamping surface 92, the associated manifolds 58, 64, valve 26 and passages 76, 86 operate in a similar way to surface 90, manifolds 60, 66, valve 30 and passages 74, 84 as described above.

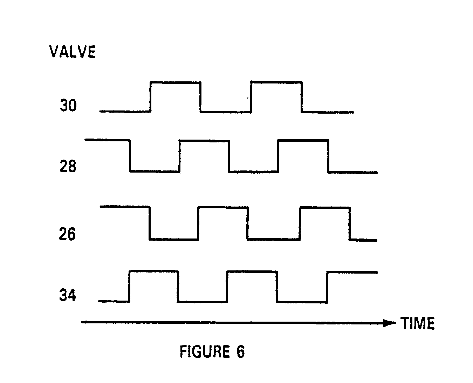

Operation of the wire stepper can be described best with reference to Figures 3 and 6. In Figure 6 the high state of the timing chart for valves 26, 28, 30, 34 indicates that the corresponding manifolds 58, 59, 60, 62, which communicate with the outlet side of the valve, are pressurized. Similarly, when the timing diagram goes low, communication between the pressure source and the manifolds is closed because the corresponding valve is closed and the manifolds are open to atmosphere. The stepping cycle begins as shown in Figure 6 with valves 26 and 28 open and valves 30 and 34 closed. With the valves so disposed, the leading portion of the wire segment located in the device is clamped against surface 92, the wire segment is held straight against vertical surface 88, as shown in position A, due to the effect of air pressure admitted to the displacement region through manifold 59, and the trailing portion of the wire segment is free to move longitudinally.

In the next step of the cycle, valve 28 closes and valve 34 opens, but valve 26 remains open and valve 30 remains closed. With the valves so disposed, the leading portion of the wire segment located within the device remains clamped against the surface 92. The trailing portion is free to move longitudinally and the intermediate portion, located in the displacement region, is moved away from surface 88 and into contact with arcuate surface 102, a segment of vertical surface 78 on the stepper plate 14. This places the wire segment in the form shown in position B of Figure 3. An additional length of wire from the trailing side of the wire segment is drawn into the stepper device in order to allow the wire to conform to the shape of surface 102 whose length is greater than that of the portion of surface 88 from which the material was moved. Because the leading portion of the wire is clamped, the required additional length of wire must necessarily be taken up from the trailing portion of the wire.

After the additional length of wire is drawn into the device, valve 26 closes, valve 30 opens, valve 28 remains closed and valve 34 remains open. This disposition of valves 28 and 34 acts to maintain the intermediate portion of the wire segment, the portion within the displacement region of the device, in contact with surface 102; however, air pressure clamps the trailing portion of the wire segment against surface 90, and closure of valve 30 acts to release the leading portion of the wire segment from being clamped on surface 92. This combination of valve states sets the stepping device so that the wire segment can be advanced in the direction of vector D.

The wire segment is advanced in the next stage of the control valve cycle by opening valve 28, closing valve 34, maintaining valve 26 closed and maintaining valve 30 open. While valve 28 is open and valve 34 is closed, the intermediate portion of the wire segment, that portion located within the displacement region, is forced away from contact with surface 102 and into contact with vertical surface 88. This straightens the wire segment and forces the incremental length of the wire in the direction of vector D by a distance that is substantially equal to the difference in length between arcuate surface 102 and the longitudinal projection of surface 102 on surface 88. In other words, the difference between the length of the dispensed material that conforms to surface 102 and the length that conforms to the straight portion of the displacement region is the length of material that is advanced during one full valve cycle.

Valves 26, 28, 30, and 34 are now in the state they originally had when the control cycle began. The cycle is repeated, either under manual control or the control of a computer, as many times as required to dispense the length of wire required. The incremental length dispensed by one full cycle of pressure valve control is determined by the difference in length of the wire segment that conforms to surface 102 and the length of the wire segment over the intermediate length that conforms to surface 88. The length of wire dispensed from the device can be varied by programming the number of cycles performed. For example, if the stepper device had been arranged to dispense 0.127 mm (0.005 inches) of wire per cycle, twenty cycles of operation would dispense 2.54 mm (0.10 inches). In the operation of the device, air pressure is maintained preferably in the range between 275.6 and 551.2 kPa (40 and 80 psi. (gauge)).

The stepper devive can be adapted to dispense material other than wire such as metal bands, ribbon tapes, paper, etc. Fluids, preferably inert gaseous fluids, other than air can be used. Vacuum, rather than positive pressure, can be used for clamping and movement of the dispensed material within the stepper device.

The device can be used to dispense material in either the direction indicated by vector D or in the reverse direction by changing the sequencing of the valves. If a metallic material is to be dispensed with this device, electromagnets can be used instead of the pressure source, valves and fluid manifolds to produce an electromagnetic stepping actuator. The actuation of such a device can be controlled by the application of electrical current to the electromagnets in the same way, and according to a similar timing schedule, as the solenoids of the pressure valves are energized.

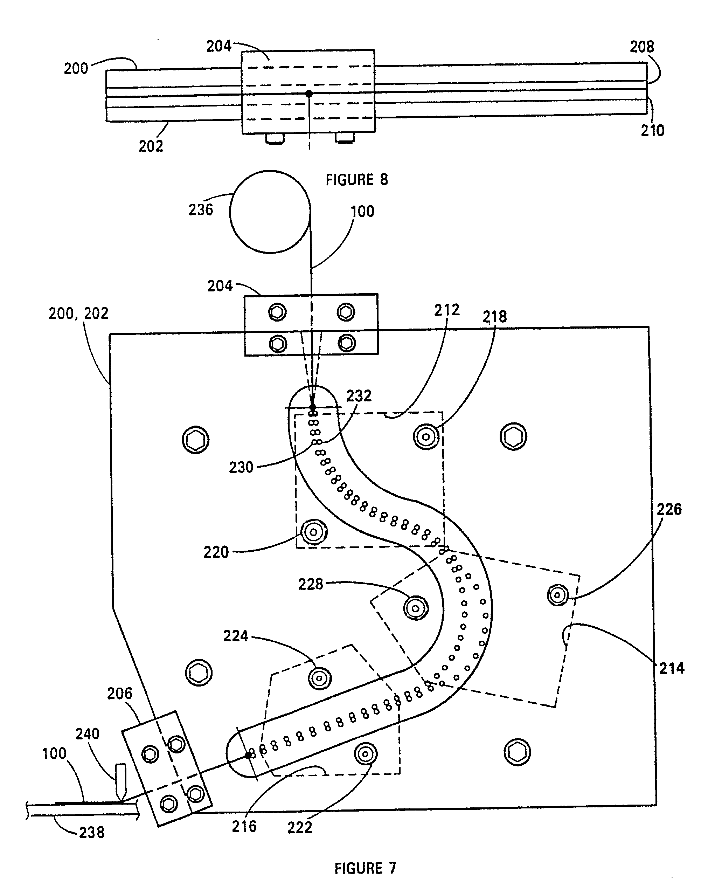

The principles of this invention are incorporated in the wire stepper device illustrated in Figures 7 and 8, to which reference is now made. The wire stepper includes upper and lower cover plates 200, 202, an inlet guide fitting 204, an outlet guide fitting 206 and intermediate plates 208, 210 which define manifolds 212, 214, 216 sealed at the upper and lower surfaces by plates 200 and 202. Manifold 212 is connected and disconnected from the source of pressurized fluid 40 by way of fitting 218, which is adapted for connection to the outlet side of valve 30. Manifold 212 is connected also to atmosphere through exhaust port 220. Similarly, manifold 216 has a fitting 222 adapted to be connected to the outlet side of valve 26, which opens and closes communication between manifold 216 and the fluid pressure source. Manifold 216 also communicates with the atmosphere through an exhaust port 224. Manifold 214 is connected to and disconnected from the fluid pressure source by way of fittings 226, 228. Fitting 226 is connected to the outlet side of valve 28, and fitting 228 is connected to the outlet side of valve 34, both valves being connected to the pressure source. The operation of valves 26, 28, 30, and 34 is controlled through the operation of a computer 36 or other control device adapted to selectively open and close the valve in accordance with the principles of this invention as previously described with respect to Figures 3 and 6.

The upper and lower plates are formed with a first row 230 and a second row 232 of pins, each mounted side-by-side, axes parallel and vertical. The pins define a path between the pin rows into which the material to be dispensed by the stepper device is guided and moves. Figure 7 schematically shows electrical wire 100 located within the device and guided through the device in the space provided between the rows of pins. However, for reasons of clarity, the wire is shown at the entrance and exit of the device, but not located within the manifolds between the pin rows. In the intermediate portion or displacement region 214 located between the outlet and inlet ends of the stepper device, the wire contacts the outer surfaces of the row of pins, which are spaced laterally from one another a greater distance than the thickness of the material and of the lateral spacing of the pin rows within manifolds 212 and 216. In the region defined by manifold 214, the pin rows are spaced apart a greater distance than required merely to receive the material between them. When the dispensed material is located within manifold 214, it moves selectively and controllably between contact with the surfaces of pin rows 230 and 232. In this way the material is drawn into the stepper device from a source of supply 236 of the material and moves toward the outlet and onto a surface such as that of a circuit board 238. In the process of placing the wire on the surface of the board, a stylus 240 can be used to develop heat for attaching the wire to the surface of the circuit board.

The operation of the stepper device of Figures 7 and 8 is controlled by the operation of the pressure valves in the manner previously described. First, the dispensed material is threaded through the device in the space defined by the adjacent surface of the pin rows 230, 232 and is lead outward from the outlet fitting 206 onto the surface of the circuit board. The dispenser is mounted on a machine that is adapted to move the dispenser in relation to the surface of the circuit board and to move stylus 240 in accordance with this motion. As the material is dispensed, the stylus operates to fix the position of the wire on the surface of the circuit board.

A typical cycle for operation of the control valves begins with valves 26 and 28 open and valves 30 and 34 closed. With the valves so disposed, the portion of the wire segment located within manifold 212 is released from pressurized contact on the pins, the portion of the wire segment located within manifold 216 is clamped against the surface of the pins of row 230 by the effect of air pressure in manifold 212 and the wire segment located within manifold 214 is forced against the surfaces of pin row 230.

A pressure difference is produced across the material located within a manifold whenever the manifold is pressurized. The pressure drop results because exhaust fittings 220 and 224 are located on the opposite side of the material from fittings 218 and 222 and fitting 228 is located on the opposite side of the material from fitting 226. When a manifold is pressurized and the dispensed material is positioned within the manifold, air flows through a constricted passage bounded by the adjacent pin surfaces, the interior surfaces of the upper and lower plates 200, 202 and the upper and lower surfaces of the dispensed material. This constriction produces lower pressure on the side of the material that is opposite the side of the material closest to fittings 218, 222 and 226, which communicate the pressure source to the manifold. The pressure difference causes the material to press against the pin row that is downstream from the pressure source.

Next, valve 28 closes and valve 34 opens, valve 30 remains closed and valve 26 remains open. The effect of this combination of valve states is to maintain the clamping attachment against pin row 230 of the wire segment located within manifold 216 while the portion of the wire segment wtihin manifold 212 is released for motion. The segment of the wire located within displacement manifold 214 is moved from contact with pin row 230 and into contact with the surfaces of the pins of row 232. This action operates to draw material from spool 236 through manifold 212 and into manifold 214.

Next, the state of valve 26 is closed and valve 30 is opened, while valves 28 and 34 remain closed and open, respectively. The effect of this combination of valve states is to clamp that portion of the wire segment located within manifold 212 against the surface of the pins of row 230, to release that portion of the wire segment located within manifold 216 from clamping contact on the pins, and to maintain that portion of the wire segment located within manifold 214 in clamping contact on the surface of the pins of row 232.

Finally, at the last state of the valve control cycle, valve 28 is turned on, valve 34 is turned off, valve 26 remains off and valve 30 remains on. This combination of valve states forces the portion of the wire segment located within displacement manifold 214 away from the surface of the pins of row 232 and into contact with the surface of the pins of row 230. While this is occurring, the portion of the wire segment located within manifold 212 remains clamped on the pin surfaces of row 230 and the portion of the wire segment located within manifold 216 is released from contact on the pins, thereby allowing the wire segment to advance through the dispensing device outward from manifold 216 through the outlet fitting 206 and onto the surface of circuit board 238.

Finally, the state of the valves is returned to that at which the cycle began: valve 26 is turned on, valve 30 is turned off and valves 28 and 34 remain on and off, respectively. The cycle is repeated according to the control of the computer as often as required to dispense the required length of material before the material is cut to the desired length.

## Claims

1. A device for dispensing controlled lengths of material characterized by

a track (63) within which movement of the material is guided, defining first and second longitudinally spaced clamping surfaces (90, 92), a displacement region located between the first and second surfaces, said region having laterally spaced surfaces (88, 102) whose lengths differ from one another by a determined length, this difference in length establishing the length of material that is dispensed from the device during each control cycle valve means (26, 28, 30, 34) for opening and closing communication between a pressure source (40) and the first surface (90), second surface (92) and surfaces (88, 102) of the displacement region; and

means for selectively controlling the opening and closing of the valve means, whereby the material to be dispensed is selectively held against the first surface (90), second surface (92) and the surfaces (88, 102) of the displacement region by the effect of the pressure source (40) when the associated valve means opens said communication, and the material is released from said surfaces when the associated valve means closes said communication.

2. The device as claimed in claim 1, characterized in that said pressure source comprises a source of pressurized gas (40).

3. The device as claimed in claim 1 or 2, characterized in that the material to be dispensed is fixed against longitudinal movement by being held against one of the clamping surfaces when the valve means opens communication between the pressure source and the selected clamping surface, the material is released from said surface when the valve means closes said communication, and the material is alternately forced to conform to one of the surfaces of the displacement region when the valve means opens communication between the pressure source and the other surface of the displacement region.

4. The device as claimed in claims 1 to 3, characterized by

a first manifold (58) selectively pressurized through operation of the valve means, extending along at least a portion of the length of the first clamping surface (92), when pressurized providing a pressure difference across the material that is located adjacent the first clamping surface (92);

a second manifold (60) selectively pressurized through operation of the valve means, extending along at least a portion of the length of the second clamping surface (90), when pressurized providing a pressure difference across the material that is located adjacent the second clamping surface (90); and

a third manifold (59, 62) selectively pressurized through operation of the valve means, extending along at least a portion of the length of the displacement region, providing a pressure difference across the material that is located within the displacement region.

5. The device as claimed in claim 4, characterized in that the first and second manifolds each include:

a supply manifold (58, 60) connected through the valve means to the pressure source and positioned on one lateral side of the material located within the respective manifold;

an exhaust manifold (64, 66) wherein the pressure is less than the pressure within the pressurized supply manifold, positioned on the opposite side of said material; and

means forming a constricted passage between the supply manifold and the exhaust manifold, whereby a pressure drop is produced from the pressurized supply manifold to the exhaust manifold across said material.

6. The device as claimed in claim 5,
characterized in that the constricted passage that connects the supply manifold and the exhaust manifold is defined at least in part by the clamping surfaces.

7. The device as claimed in claims 4 to 6,
characterized in that the third manifold (59, 62) includes a supply manifold communicating through the valve means selectively to the pressure source and to the atmosphere and positioned on one lateral side of the material located within the third manifold, and exhaust manifold communicating through the valve means selectively to the pressure source and to the atmosphere and positioned on the opposite side of said material, and means forming a constricted passage between the supply manifold and the exhaust manifold, whereby a pressure difference can be produced from the supply manifold to the exhaust manifold across said material.

8. The device as claimed in claims 1 to 7,

characterized in that the valve means includes first and second two-way valves, the exhaust port of the first valve being disposed in the first manifold, the exhaust port of the second valve being disposed in the second manifold, and third and fourth three-way valves each having an exhaust port disposed in the third manifold, one in the supply manifold and the other in the exhaust manifold, and a port communicating to atmosphere when their supply port is closed to the pressure source; each of said valves having its supply port connected to the pressure source.

9. The device as claimed in claims 1 to 8,
characterized in that the track comprises two rows of pins (230, 232), the pins of each row being arranged side-by-side, spaced longitudinally from one another with their axes vertical and parallel to one another, the pin rows defining the first clamping surface and the second clamping surface wherein the rows are spaced laterally from one another a distance that permits the dispensed material to pass between the facing pin surfaces of the pin rows, the pin rows defining the displacement region wherein the rows are spaced laterally from one another and the length of one pin row is substantially greater than the length of the other pin row.

10. The device as claimed in claim 9,
characterized in that the device includes upper and lower closure members and wherein the constricted passage is defined at least in part by the longitudinal distances between adjacent pins of a row of pins, the vertical distances between the upper surface of said material and the interior surface of the upper closure member, and the vertical distance between the lower surface of said material and the interior surface of the lower closure member.

## Revendications

1. Dispositif pour la délivrance de longueurs contrôlées de matériau, caractérisé par une liaison (63) à l'intérieur de laquelle le mouvement du matériau est guidé, définissant une première et une seconde surface de fixation (90,92) séparées longitudinalement, une zone de déplacement située entre les première et seconde surfaces, ladite zone ayant des surfaces espacées latéralement (88,102) dont les longueurs diffèrent l'une de l'autre par une distance déterminée, cette différence de distance établissant la longueur du matériau provenant du dispositif au cours de chaque cycle de contrôle ; un système de vannes (26,28,30,34) pour ouvrir et fermer le passage entre une source de pression (40) et la première surface (90), la seconde surface (92) et les surfaces (88,102) de la zone de déplacement ; et un moyen pour commander sélectivement l'ouverture et la fermeture du système de vannes, par lequel le matériau à délivrer est maintenu sélectivement contre la première surface (90), la seconde surface (92) et les surfaces (88,102) de la zone de déplacement sous l'effet de la source de pression (40) lorsque le système de vannes associé ouvre ledit passage, et le matériau est dégagé desdites surfaces lorsque le système de vannes associé ferme ledit passage.

2. Dispositif selon la revendication 1, caractérisé en ce que ladite source de pression comprend une source de gaz sous pression (40).

3. Dispositif selon la revendication 1 ou 2, caractérisé en ce que le matériau à délivrer est empêché d'avoir un mouvement longitudinal en étant maintenu contre l'une des surfaces de fixation lorsque le système de vannes ouvre le passage entre la source de pression et la surface de fixation sélectionnée, le matériau est dégagé de ladite surface lorsque le système de vannes ferme ledit passage, et le matériau est contraint en alternance de s'adapter à l'une des surfaces de la zone de déplacement lorsque le système de vannes ouvre le passage entre la source de pression et l'autre surface de la zone de déplacement.

4. Dispositif selon les revendications 1 à 3, caractérisé par un premier collecteur (58) mis sous pression sélectivement par l'actionnement du système de vannes, s'étendant le long d'au moins une partie de la longueur de la première surface de fixation (92), et fournissant, lorsqu'il est mis sous pression, une différence de pression à travers le matériau qui est situé de façon adjacente à la première surface de fixation (92) ; un deuxième collecteur (60) mis sous pression sélectivement par l'actionnement du système de vannes, s'étendant le long d'au moins une partie de la longueur de la seconde surface de fixation (90), et fournissant, lorsqu'il est mis sous pression, une différence de pression à travers le matériau qui est situé de façon adjacente à la seconde surface de fixation (90) ; et un troisième collecteur (59,62) mis sous pression sélectivement par l'actionnement du système de vannes, s'étendant le long d'au moins une partie de la longueur de la zone de déplacement, fournissant une différence de pression à travers le matériau qui est situé à l'intérieur de la zone de déplacement.

5. Dispositif selon la revendication 4, caractérisé en ce que le premier et le deuxième collecteur sont soumis chacun : d'un collecteur d'alimentation (58,60) relié par le système de vannes à la source de pression, et placé sur un côté latéral du matériau situé à l'intérieur de son collecteur respectif ; un collecteur d'échappement (64,66) dans lequel la pression est inférieure à la pression maintenue dans le collecteur d'alimentation mis sous pression, placé sur le côté opposé dudit matériau ; et un dispositif formant un passage rétréci entre le collecteur d'alimentation et le collecteur d'échappement, dans lequel une chute de pression est produite depuis le collecteur d'alimentation sous pression jusqu'au collecteur d'échappement, en traversant ledit matériau.

6. Dispositif selon la revendication 5, caractérisé en ce que le passage resserré qui relie le collecteur d'alimentation au collecteur d'échappement, est défini, au moins partiellement, par les surfaces de fixation.

7. Dispositif selon les revendications 4 à 6, caractérisé en ce que le troisième collecteur (59,62) comprend un collecteur d'alimentation communiquant par l'intermédiaire du système de vannes sélectivement avec la source de pression et l'atmosphère, et placé sur un côté latéral du matériau situé à l'intérieur du troisième collecteur, un collecteur d'échappement communiquant par l'intermédiaire du système de vannes sélectivement avec la source de pression et l'atmosphère, et placé sur le côté opposé dudit matériau, et un dispositif formant un passage rétréci entre le collecteur d'alimentation et le collecteur d'échappement, dans lequel une différence de pression peut être produite depuis le collecteur d'alimentation jusqu'au collecteur d'échappement, à travers ledit matériau.

8. Dispositif selon les revendications 1 à 7, caractérisé en ce que le système de vannes comprend une première et une deuxième soupape à deux voies, l'orifice d'échappement de la première soupape étant situé dans le premier collecteur, l'orifice d'échappement de la seconde soupape étant situé dans le deuxième collecteur, et une troisième et une quatrième soupape à trois voies possédant chacune un orifice d'échappement situé dans le troisième collecteur, l'une dans le collecteur d'alimentation et l'autre dans le collecteur d'échappement, et un orifice communiquant avec l'atmosphère lorsque leur orifice d'alimentation est fermé à la source de pression ; chacune desdites soupapes ayant son orifice d'alimentation relié à la source de pression.

9. Dispositif selon les revendications 1 à 8, caractérisé en ce que la glissière comprend deux rangées de chevilles ou broches (230,232), les broches de chaque rangée étant disposées côte à côte, espacées longitudinalement les unes des autres et leurs axes étant verticaux et parallèles les uns avec les autres, les rangées de broches définissant la première surface de fixation et la seconde surface de fixation, les rangées étant espacées latéralement l'une de l'autre d'une distance qui permet au matériau dispensé de passer entre les surfaces en regard des broches des rangées de broches, lesdites rangées de broches définissant la zone de déplacement dans laquelle les rangées sont espacées latéralement l'une de l'autre et la longueur de l'une des rangées de broches est substantiellement plus grande que celle de l'autre rangée de broches.

10. Dispositif selon la revendication 9, caractérisé en ce que le dispositif comprend des éléments de fermeture supérieur et inférieur et dans lesquels le passage rétréci est défini au moins en partie par les distances longitudinales entre les broches adjacentes d'une même rangée de broches, les distances verticales entre la surface supérieure dudit matériau et la surface intérieure de l'élément de fermeture supérieur, et la distance verticale entre la surface inférieure dudit matériau et la surface intérieure de l'élément de fermeture inférieur.

**Patentansprüche**

1. Gerät zum Austeilen gesteuerter Längen eines Materials, gekennzeichnet durch

eine Bahn (63), innerhalb deren die Bewegung des Materials geführt wird, die erste und zweite in Längsrichtung im Abstand angeordnete Einspannflächen (90, 92) definiert, einen zwischen den ersten und zweiten Flächen gelegenen Verschiebungsbereich, der in seitlichem Abstand angeordnete Flächen (88, 102) aufweist, deren Längen sich voneinander um eine vorgegebene Länge unterscheiden, wobei der Längenunterschied die Länge des Materials bestimmt, die vom dem Gerät während jedes Steuerzyklus ausgeteilt wird,

eine Ventilvorrichtung (26, 28, 30, 34) zum Öffnen und Schließen des Verbindungsweges zwischen einer Druckquelle (40) und der ersten Fläche (90), der zweiten Fläche (92) und den Flächen (88, 102) des Verschiebungsbereiches und

eine Vorrichtung zum wahlweisen Steuern des Öffnens und Schließens der Ventilvorrichtung, wodurch das auszuteilende Material selektiv gegen die erste Fläche (90), die zweite Fläche (92) und die Flächen (88, 102) des Verschiebungsbereiches durch die Wirkung der Druckquelle (40) gehalten wird, wenn die zugeordnete Ventilvorrichtung den Verbindungsweg öffnet, und das Material von den Flächen abgelöst wird, wenn die zugeordnete Ventilvorrichtung den Verbindungsweg schließt.

2. Gerät nach Anspruch 1, dadurch gekennzeichnet, daß die Druckquelle aus einer Quelle (40) für ein unter Druck stehendes Gas besteht.

3. Gerät nach den Ansprüchen 1 oder 2, dadurch gekennzeichnet, daß das auszuteilende Material gegen eine Bewegung in Längsrichtung dadurch gesichert wird, daß es gegen eine der Einspannflächen geklemmt wird, wenn die Ventilvorrichtung den Verbindungsweg zwischen der Druckquelle und der ausgewählten Einspannfläche öffnet, daß das Material von der Fläche abgelöst wird, wenn die Ventilvorrichtung den Verbindungsweg schließt und daß das Material abwechselnd gezwungen wird, sich einer der Flächen des Verschiebungsbereiches anzupassen, wenn die Ventilvorrichtung den Verbindungsweg zwischen der Druckquelle und der anderen Fläche des Verschiebungsbereiches öffnet.

4. Gerät nach den Ansprüchen 1 bis 3, gekennzeichnet durch

ein erstes Verteilerrohrsystem (58), das durch die Betätigung der Ventilvorrichtung selektiv unter Druck gesetzt wird und sich zumindest längs eines Teiles der Länge der ersten Einspannfläche (92) erstreckt und das, wenn es unter Druck steht, einen Druckunterschied quer zu dem Material liefert, das an die erste Einspannfläche (92) angrenzt,

ein zweites Verteilerrohrsystem (60), das durch die Betätigung der Ventilvorrichtung selektiv unter Druck gesetzt wird und sich zumindest längs eines Teiles der Länge der zweiten Einspannfläche (90) erstreckt und das, wenn es unter Druck gesetzt wird, einen Druckunterschied quer zu dem Material liefert, das an die der zweite Einspannfläche (90) angrenzt und

ein drittes Verteilerrohrsystem (59, 62), das durch Betätigen der Ventilvorrichtung selektiv unter Druck gesetzt wird und sich zumindest längs eines Teiles der Länge des Verschiebungsbereiches erstreckt und einen Druckunterschied quer zu dem Material liefert, das sich innerhalb des Verschiebungsbereiches befindet.

5. Gerät nach Anspruch 4, dadurch gekennzeichnet, daß das erste und zweite Verteilerrohrsystem jeweils einschließen:

ein Zuführverteilerrohr (58, 60), das durch die Ventilvorrichtung mit der Druckquelle verbunden ist und auf einer Seite des Materials angeordnet ist, das sich innerhalb des betreffenden Verteilerrohrsystems befindet,

ein Auslaßverteilerrohr (64, 66), in dem der Druck geringer ist als der Druck innerhalb des unter Druck stehenden Zuführverteilerrohres, das auf der gegenüberliegenden Seite des Materials angeordnet ist und

eine Vorrichtung zum Bilden eines verengten Durchlasses zwischen dem Zuführverteilerrohr und dem Auslaßverteilerrohr, wobei ein Druckabfall quer zu dem Material von dem unter Druck stehenden Zuführverteilerrohr zu dem Auslaßverteilerrohr hervorgerufen wird.

6. Gerät nach Anspruch 5, dadurch gekennzeichnet, daß der verengte Durchlaß, der das Zuführverteilerrohr und das Auslaßverteilerrohr verbindet, zumindest teilweise durch die Einspannflächen definiert ist.

7. Gerät nach den Ansprüchen 4 bis 6, dadurch gekennzeichnet, daß das dritte Verteilerrohrsystem (59, 62) ein Zuführverteilerrohr einschließt, das über die Ventilvorrichtung selektiv mit der Druckquelle und mit der Atmosphäre in Verbindung steht und das auf einer Seite des Materials angeordnet ist, das sich innerhalb des dritten Verteilerrohrsystems befindet, und ein Auslaßverteilerrohr, das über die Ventilvorrichtung selektiv mit der Druckquelle und mit der Atmosphäre in Verbindung steht und das auf einer Seite des Materials angeordnet ist, und eine Vorrichtung, die einen verengten Durchlaß zwischen dem Zuführverteilerrohr und dem Auslaßverteilerrohr bildet, wodurch ein Druckunterschied quer zum Material von dem Zuführverteilerrohr zu dem Auslaßverteilerrohr hervorgerufen werden kann.

8. Gerät nach den Ansprüchen 1 bis 7, dadurch gekennzeichnet, daß die Ventilvorrichtung erste und zweite Zweiweg-Ventile einschließt, wobei die Auslaßöffnung des ersten Ventils in dem ersten Verteilerrohrsystem angeordnet ist, die Auslaßöffnung des zweiten Ventils in dem zweiten Verteilerrohrsystem angeordnet ist, und dritte und vierte Dreiweg-Ventile, von denen jedes eine Auslaßöffnung aufweist, die in dem dritten Verteilerrohrsystem angeordnet sind, eine in dem Zuführverteilerrohrsystem und die andere in dem Auslaßverteilerrohrsystem, wobei die Zuführöffnung zur Druckquelle geschlossen ist und die Zuführöffnung jedes der Ventile mit der Druckquelle verbunden ist.

9. Gerät nach den Ansprüchen 1 bis 8, dadurch gekennzeichnet, daß die Bahn zwei Stiftreihen (230, 232) aufweist, und die Stifte jeder Reihe Seite an Seite angeordnet sind und in Längsrichtung einen Abstand voneinander aufweisen, wobei ihre Achsen vertikal und parallel zueinander angeordnet sind, die Stiftreihen die erste und zweite Einspannfläche definieren, in denen die Reihen mit seitlichem Abstand voneinander in einer Entfernung angeordnet sind, die es erlaubt, daß das ausgeteilte Material zwischen den gegenüberliegenden Stiftflächen der Stiftreihen vorbeilaufen kann, wobei die Stiftreihen den Verschiebungsbereich definieren, in dem die Reihen einen seitlichen Abstand voneinander aufweisen und die Länge der einen Stiftreihe wesentlich größer als die Länge der anderen Stiftreihe ist.

10. Gerät nach Anspruch 9, dadurch gekennzeichnet, daß das Gerät obere und untere Abschlußglieder aufweist und der verengte Durchgang zumindest zum Teil durch die Abstände in Längsrichtung zwischen benachbarten Stiften einer Stiftreihe, den vertikalen Abständen zwischen der oberen Fläche des Materials und der unteren Fläche des oberen Abschlußgliedes und dem vertikalen Abstand zwischen der unteren Fläche des Materials und der inneren Fläche des unteren Abschlußgliedes definiert ist.

FIGURE 1

FIGURE 2

POSITION A
POSITION B
POSITION C

FIGURE 3

FIGURE 4

FIGURE 5

VALVE

FIGURE 6

FIGURE 8

FIGURE 7